# EUROPEAN PATENT APPLICATION

(11) **EP 4 389 280 A2**
(43) Date of publication of application: **26.06.2024**
(21) Application number: 23188005.5
(22) Date of filing: 27.07.2023
(51) Int. Cl.: B01L 3/00, C23C 14/06, C23C 14/58, C23C 14/34, G01N 1/44, G01N 21/03

(54) **NANOSTRUCTURED SYSTEM FOR NUCLEIC ACID AMPLIFICATION**

(30) Priority: 19.12.2022 US 202263433723 P; 19.01.2023 US 202318157001
(71) Applicant: Samsung Electronics Co., Ltd., Suwon-si, Gyeonggi-do 16677 (KR)
(72) Inventor: NARASIMHAN, Vinayak, San Jose, CA, 95134 (US); NAMKOONG, Kak, San Jose, CA, 95134 (US); SIDDIQUE, Radwanul Hasan, San Jose, CA, 95134 (US); JUNG, Wonjong, San Jose, CA, 95134 (US); YOON, Youngzoon, San Jose, CA, 95134 (US)
(74) Representative: Kuhnen & Wacker Patent- und Rechtsanwaltsbüro PartG mbB

(57) **Abstract**

An assay repository device for photothermal or joule heating includes an assay container having an interior surface and being configured to house an assay solution, and a nanostructure layer conformally integrated onto the assay container and directly contacting the interior surface, the nanostructure layer being plasmonic and thermally conductive, and including a plurality of nanofeatures having non-uniform sizes and/or non-uniform shapes.

## Description

### FIELD

Aspects of the invention relate to the field of photothermal heating.

### BACKGROUND

Polymerase chain reaction (PCR) is considered the industry gold-standard nucleic acid (NA) amplification method. Amplification occurs by creating copies of the target nucleic acid cyclically. The amplification process involves cyclical thermocycling heating of the solution in which the NA is present and careful monitoring of the solution temperature.

Typical NA amplification tests take about one hour to perform. The test duration is often limited by the large reaction volumes, which result in large differences between the thermocycler heat block temperature and the sample temperature, and slow average heat ramp rates of traditional PCR reaction containers due to their poor thermal conductivity. This slows the reaction and additional calibration is needed to monitor sample temperature with more precision.

The above information disclosed in this Background section is only for enhancement of understanding of the background of the invention, and therefore it may contain information that does not form the prior art.

### SUMMARY

Aspects of embodiments of the present invention are directed toward a multifunctional nanostructure layer integrated with PCR reaction containers. The nanostructure layer provides rapid heat transfer to sample from a light source or a heat block. In some examples, the feature dimensions of the nanostructure layer may be tuned to absorb most or nearly all of light in the ultraviolet-visible-near infrared wavelength ranges (e.g., about 250 nm to about 1000 nm). The plasmonically active and thermally-conductive nanostructure layer, which can be conformally integrated onto all forms of PCR reaction chambers, provides high heat ramp and cool down rates through photothermal or joule heating, thus enabling rapid lysis and thermocycling, which yields shorter testing time.

According to some exemplary embodiments of the present invention, there is provided an assay repository device for photothermal or joule heating, the assay repository device including: an assay container having an interior surface and being configured to house an assay solution; and a nanostructure layer conformally integrated onto the assay container and directly contacting the interior surface, the nanostructure layer being plasmonic and thermally conductive, and including a plurality of nanofeatures having non-uniform sizes and/or non-uniform shapes.

In some embodiments, the assay container includes a reaction tube, a well plate, a lab-on-chip, or a microarray.

In some embodiments, the nanostructure layer has a uniform thickness along the interior surface of the assay container, and the interior surface includes a non-flat surface portion.

In some embodiments, the nanostructure layer is configured to be directly contacting the assay solution in the assay container.

In some embodiments, the nanostructure layer is configured to increase heat ramp and cooldown rates of the assay repository device to enable rapid lysis or thermocycling.

In some embodiments, the nanostructure layer is configured to absorb more than 90% of incoming light in an ultraviolet to near infrared wavelength range, and the nanostructure layer has a thermal conductivity greater than 100 W/mK.

In some embodiments, each one of the plurality of nanofeatures has a circular shape, a spherical shape, an ellipsoidal shape, a prismatic shape, or a tapered shape.

In some embodiments, the nanostructure layer includes at least one of a metal, a doped semiconductor, or an undoped semiconductor.

In some embodiments, the nanostructure layer includes at least one of aluminum (Al), gold (Au), silver (Ag), titanium (Ti), tungsten (W), copper (Cu), palladium (Pd), tantalum (Ta), tantalum nitride (TaN), titanium nitride (TiN), Niobium (Nb), or p-doped silicon (p Si).

According to some exemplary embodiments of the present invention, there is provided a method of heating of an assay solution, the method including: providing an assay repository device including: an assay container having an interior surface and being configured to house the assay solution; and a nanostructure layer conformally integrated onto the assay container and directly contacting the interior surface, the nanostructure layer being plasmonic and thermally conductive, and including a plurality of nanofeatures having non-uniform sizes and/or non-uniform shapes; and performing photothermal heating or joule heating of the assay repository device.

In some embodiments, the method further includes: providing the assay solution in the assay container.

In some embodiments, the performing the photothermal heating or the joule heating of the assay repository device includes: emitting, by a light emitting diode (LED) or a laser, light of a wavelength range toward an interior of the assay container for absorption by the nanostructure layer.

In some embodiments, in the wavelength range includes an ultraviolet to near infrared wavelength range.

In some embodiments, the performing the photothermal heating or the joule heating of the assay repository device includes: providing a joule heater in contact with the assay repository device; and generating heat by the joule heater.

In some embodiments, the nanostructure layer has a uniform thickness along the interior surface of the assay container, and the interior surface includes a non-flat surface portion.

In some embodiments, the nanostructure layer includes at least one of a metal, a doped semiconductor, or an undoped semiconductor.

According to some exemplary embodiments of the present invention, there is provided a method of manufacturing an assay repository device, the method including: providing an assay container having an interior surface and being configured to house an assay solution; depositing, by thin film sputtering, a plasmonic and thermally conductive material on the interior surface of the assay container; and growing a nanostructure layer by performing high temperature annealing of the plasmonic and thermally conductive material, the nanostructure layer being conformally integrated onto the assay container and directly contacting the interior surface, the nanostructure layer being plasmonic and thermally conductive, and including a plurality of nanofeatures having non-uniform sizes and/or non-uniform shapes.

In some embodiments, the nanostructure layer is configured to be directly contacting the assay solution in the assay container.

In some embodiments, the plasmonic and thermally conductive material is about 4 nm to about 25 nm thick, and the performing the high temperature annealing includes raising a temperature of the assay container to about 400 °C to about 800 °C and then cooling it down to room temperature.

In some embodiments, the nanostructure layer has a uniform thickness along the interior surface of the assay container, and the interior surface includes a non-flat surface portion.

### BRIEF DESCRIPTION OF THE DRAWINGS

The above and other features and aspects of the invention will be made more apparent by the following detailed description of exemplary embodiments thereof with reference to the attached drawings, in which:
FIG. 1 illustrates a diagnostics system including an assay repository device integrated with a nanostructure layer, according to some embodiments of the present invention.
FIG. 2A illustrates a conformal sub-micrometer nanostructure layer on a section of a microarray platform, according to some embodiments of the present invention.
FIG. 2B illustrates a cross-section of the microarray platform taken along the line A-A' of FIG. 2A, according to some embodiments of the present invention.
FIG. 3A illustrates the conformal sub-micrometer nanostructure layer on a microfluidic PCR platform, according to some embodiments of the present invention.
FIG. 3B illustrates a cross-section of the microfluidic PCR platform taken along the line B-B' of FIG. 3A, according to some embodiments of the present invention.
FIG. 4A illustrates a standard PCR platform with PCR tubes that are integrated with conformal sub-micrometer nanostructure layers, according to some embodiments of the present invention.
FIG. 4B illustrates a zoomed-in top view of the nanostructure layer, according to some embodiments of the present invention.
FIG. 5A illustrates the process of depositing a nanostructure layer on a planar substrate, and FIG. 5B illustrates the process of depositing a nanostructure layer on an uneven substrate, according to some embodiments of the present invention.
FIG. 6A illustrates the result of the deposition in FIG. 5A, and FIG. 6B illustrates the result of the deposition in FIG. 5B, according to some embodiments of the present invention.
FIGS. 7A-7C illustrate the effect of the annealing temperature on size and density of nanofeatures of the nanostructure layer, according to some embodiments of the present invention.
FIGS. 8A-8C illustrate the effect of the sputtering time on thickness of the nanostructure layer and the size of the nanofeatures, according to some embodiments of the present invention.
FIG. 9 is a graph illustrating the effect that the nanostructure layer has on improving the maximum temperature and the heat ramp of the assay repository device, according to some embodiments of the present invention.
FIG. 10 illustrates a process of heating of an assay solution, according to some embodiments of the present invention.
FIG. 11 illustrates a process of manufacturing an assay repository device, according to some embodiments of the present invention.

### DETAILED DESCRIPTION

The attached drawings for illustrating exemplary embodiments of the invention are referred to in order to provide a sufficient understanding of the invention, the merits thereof, and the objectives accomplished by the implementation of the invention. The invention may, however, be embodied in many different forms and should not be construed as being limited to the exemplary embodiments set forth herein; rather, these exemplary embodiments are provided so that this invention will be thorough and complete, and will fully convey the concept of the invention to those skilled in the art.

Hereinafter, the invention will be described in detail by explaining exemplary embodiments of the invention with reference to the attached drawings. In the drawings, like reference numerals are used throughout the figures to reference like features and components.

Aspects of embodiments of the present invention are directed to an assay repository device that is integrated with a conformal multifunctional nanostructure layer. The nanostructure layer provides rapid and efficient heat transfer to a sample from a light source or a joule heater.

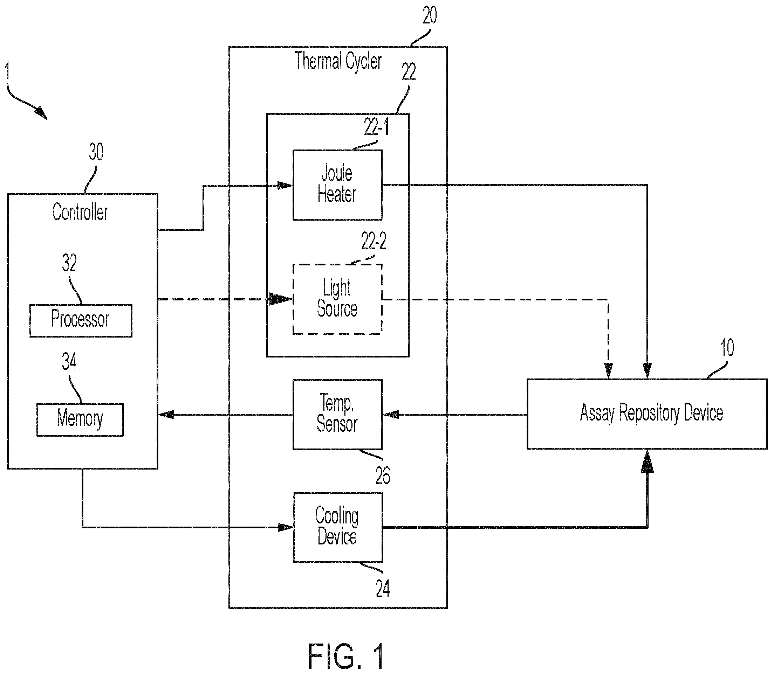

FIG. 1 illustrates a diagnostics system 1, according to some embodiments of the present invention.

Referring to FIG. 1, the diagnostics system 1 may facilitate the amplification of segments of deoxyribonucleic acid (DNA) using the polymerase chain reaction (PCR) by carefully controlling and cycling the temperature of a solution containing the DNA strands. In some embodiments, the diagnostics system 1 (also referred to as a PCR diagnostics system) includes an assay repository device 10 that acts as the container for the solution that includes the DNA strands, a thermal cycler 20 for heating and cooling the assay repository device 10, and a controller 30 for controlling the thermal cycler 20 to produce the desired thermal cycles that enable DNA amplification.

The thermal cycler 20 may include a heating device 22 for transferring heat to, and ramping up the temperature of, the assay repository device 10. In some examples, the heating device 22 may be a joule heater (e.g., resistive heater) 22-1, which converts electric energy into thermal energy. However, in some examples, the heating device 22 may instead perform photothermal heating by utilizing a light source 22-2, which may include a laser or one or more light emitting diodes (e.g., LEDs), to emit light of a particular wavelength range (e.g., 250 nm to about 1000 nm) toward the assay repository device 10. The emitted light may be absorbed by the assay repository device 10 causing the solution to heat up. To cool and ramp down the temperature of the assay repository device 10, the thermal cycler 20 uses a cooling device 26, which may be a cooling fan, a thermoelectric cooler (TEC) or a liquid cooling module.

The temperature sensor (e.g., thermistor) 26 allows the controller 30 to monitor the temperature the solution contained in the assay repository device 10 and thus accurately regulate the temperature cycles by controlling the operations (e.g., activating/turning on and deactivating/turning off) of the heating device 22 and the cooling device 24. The controller 30 may include a processor 32 and a memory 34 local to the processor 32, which has instructions stored thereon that, when executed by the processor 32, cause the processor 32 to perform the processing operations of the controller 30.

The assay repository device 10 may include a reaction tube (e.g., a PCT test tube), a well plate, a lab-on-chip, or a microarray having one or more wells that contain a sample (e.g., a fluid) with a plurality of target molecules, such as DNA strands. According to some embodiments, the assay repository device 10 is integrated with a nanostructure layer, which significantly improves (e.g., increases) the ability of the assay repository device 10 to absorb heat, whether through joule heating or photothermal heating, and to increase the temperature of the sample. As such, the assay repository device 10 with integrated nanostructure layer is capable of significantly increasing the rate at which the sample temperature can be raised, thus shortening the duration of each thermal cycle and substantially increasing the speed at which PCR amplification may be performed. For example, by utilizing the assay repository device 10, thermal cycling time may be reduced from about 45 minutes to about an hour (as may be the case in the related art) to about 10 mins or less.

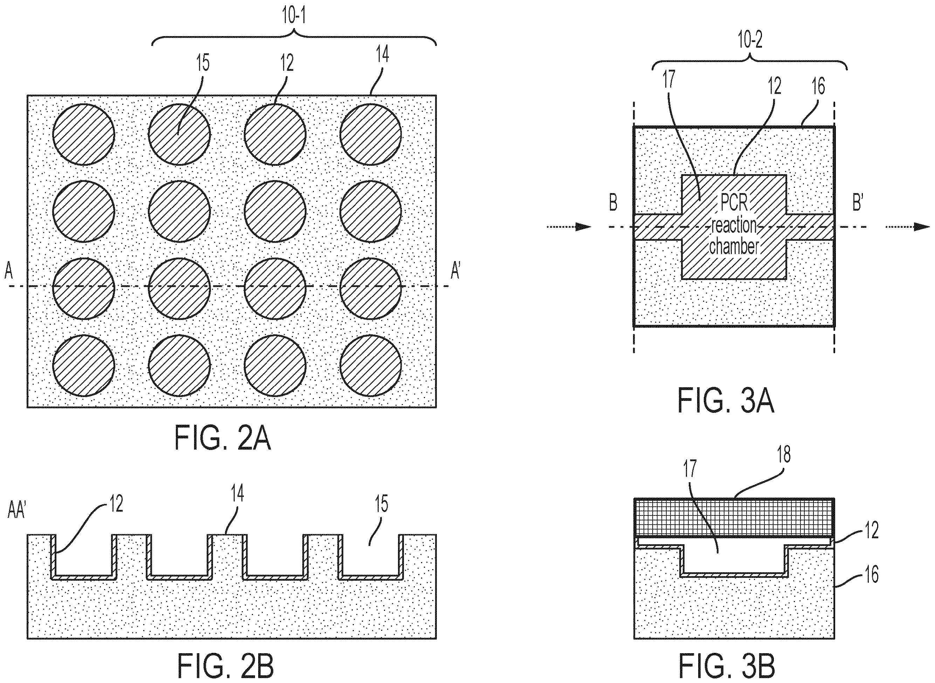

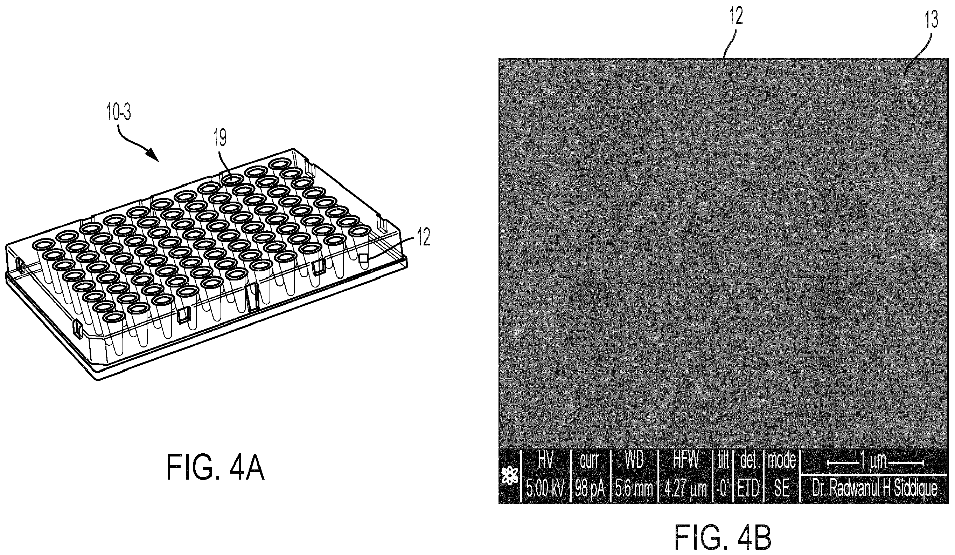

FIG. 2A illustrates the conformal sub-micrometer nanostructure layer 12 on a section of a microarray platform 14, according to some embodiments of the present invention. FIG. 2B illustrates a cross-section of the microarray platform 14 along the line A-A', according to some embodiments of the present invention. FIG. 3A illustrates the conformal sub-micrometer nanostructure layer 12 on a microfluidic PCR platform 16, according to some embodiments of the present invention. FIG. 3B illustrates a cross-section of the microfluidic PCR platform 16 along the line B-B', according to some embodiments of the present invention. FIG. 4A illustrates a standard PCR platform with PCR tubes, which are integrated with conformal sub-micrometer nanostructure layers, according to some embodiments of the present invention. FIG. 4B illustrates a zoomed-in top view of the nanostructure layer 12, according to some embodiments of the present invention.

As shown in FIGS. 2A-2B and 3A-3B, the nanostructure layer 12 is conformally formed (e.g., formed with uniform thickness) along an interior surface of the assay repository device 10, which contains the assay solution. The nanostructure layer 12 may maintain a uniform thickness even on non-flat (e.g., curved or uneven) surfaces. In some examples, the assay repository device (10-1) may include a microarray platform 14 (as shown in FIGS. 2A-2B) with one or more wells 15 that can store a solution including one or more DNAs molecules. The wells 15 may have round side surfaces and sharp angles between side and bottom surfaces, which are all coated with a nanostructure layer 12 of uniform thickness.

In other examples, the assay repository device 10 may include a microfluidic PCR platform 16 (as shown in FIGS. 3A-3B) that facilitates the flow of assay solution into and through a PCR reaction chamber 17. The reaction chamber 17 may include surfaces that adjoin at sharp angles, all of which are coated with the uniform nanostructure layer 12. The platform 16 may include a sealing layer 18 (e.g., a glass or plastic layer) to protect the assay solution from the elements.

In still other examples, the assay repository device 10 may include a standard PCR platform 10-3 (as shown in FIG. 4A) having PCR tubes 19, each of which has a curved interior surface coated with the conformal nanostructure layer 12 and contains the assay solution. In the foregoing examples, the nanostructure layer 12 is in direct contact with the assay solution thus greatly amplifying the heat transfer from the nanostructure layer 12 to the assay solution and its constituent sample molecules (e.g., DNA segments).

As shown in FIG. 4B, in some embodiments, the nanostructure layer 12 includes a plurality of nanofeatures 13 that are concurrently (e.g., simultaneously) formed of the same material, thus creating a unitary and monolithic layer. The nanostructure layer 12 may include at least one of a metal, a doped semiconductor, or an undoped semiconductor. According to some examples, the nanostructure layer 12 may include aluminum (Al), gold (Au), silver (Ag), titanium (Ti), tungsten (W), copper (Cu), palladium (Pd), tantalum (Ta), tantalum nitride (TaN), titanium nitride (TiN), Niobium (Nb), p-doped silicon (p Si), and/or the like.

In some embodiments, the nanostructure layer 12 is plasmonic and thermally conductive. The light absorption properties of the nanostructure layer 12 may depend on the structure, shape, and size of the nanofeatures 13 as well as the spacing between them, at least some of which may be tuned as desired to a particular application. For example, each one of the plurality nanofeatures may have a circular shape, a spherical shape, an ellipsoidal shape, a prismatic shape, or a tapered shape. Further, in some embodiments, the nanofeatures 13 may be non-uniform in size and shape, which may allow the nanostructure layer 12 to absorb a broadband spectrum of light wavelengths. For example, the nanostructure layer 12 may absorb about 90% or more of incoming light in the ultraviolet to near infrared wavelengths (e.g., 250 nm to about 1000 nm). In so doing, the nanostructure layer 12 may effectively substantially reduce the native reflection of the underlying container surface, which may be silicon, plastic, or the like. This makes the assay repository device 10 particularly useful in photothermal and joule heating applications.

The nanostructure layer 12 may also exhibit high thermal conductivity. For example, the nanostructure layer 12 may have a thermal conductivity greater than 100 W/mK. Therefore, the heat generated by the nanostructure layer 12 may be readily transferred to the assay solution to which it is direct contact. This greatly increases the heat ramp and cooldown rates of the assay repository device 10 to enable rapid lysis or thermocycling.

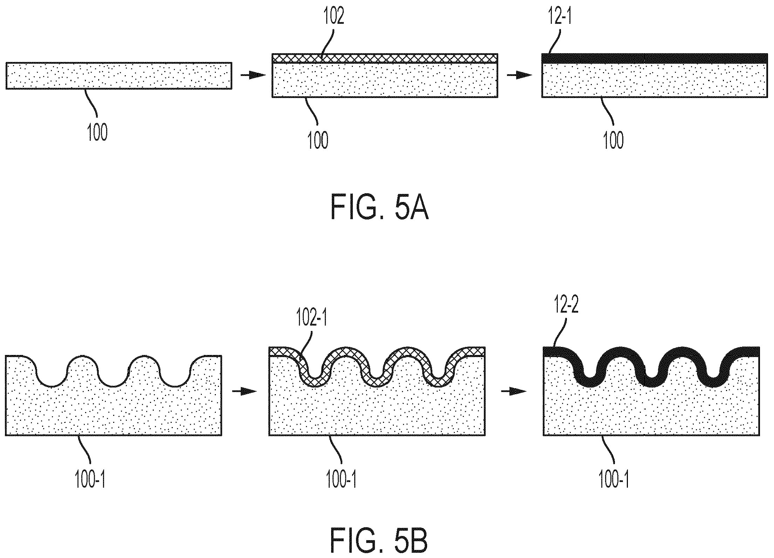

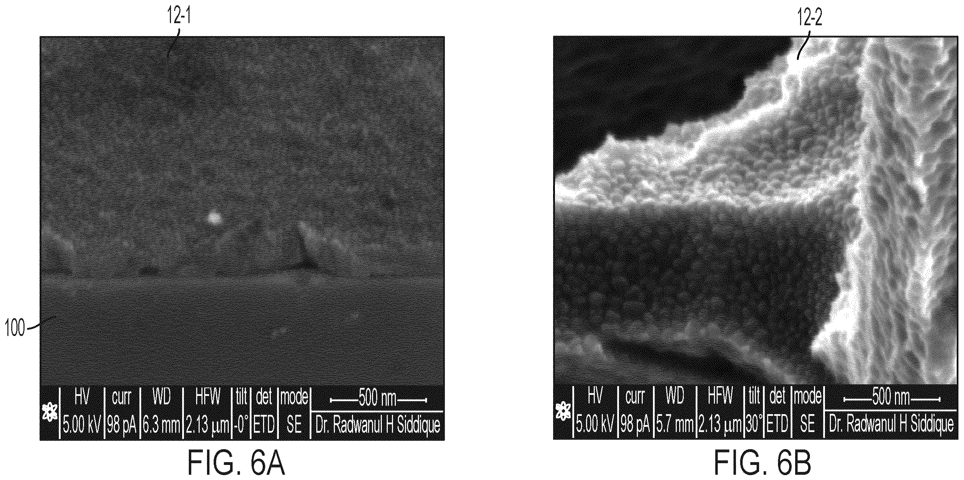

FIG. 5A illustrates the process of depositing a nanostructure layer 12-1 on a planar substrate 100, and FIG. 5B illustrates the process of depositing a nanostructure layer 12-2 on an uneven substrate 100-1, according to some embodiments of the present invention. FIG. 6A illustrates the result of the deposition in FIG. 5A, and FIG. 6B illustrates the result of the deposition in FIG. 5B, according to some embodiments of the present invention.

Referring to FIGS. 5A and 6A, in some embodiments, the process of forming a nanostructure layer 12 on a substrate 100/100-1 (e.g., the interior of a test tube, a well, a chamber, etc.) includes depositing, by thin film sputtering, a plasmonic and thermally conductive material 102/102-1 (such as those described with respect to FIG. 4B) on the interior surface of the substrate. The deposited layer 102/102-1 may be about 4 nm to about 25 nm thick.

The process further includes growing nanofeatures 13-1/13-2 of the nanostructure layer 12-1/12-2 by performing high temperature annealing of the sputtered material 102/102-1. The annealing may involve heating the sputtered material 102/102-1 to about 400 °C to about 800 °C and then cooling it down to room temperature (e.g., under vacuum condition).

As shown in FIGS. 6A-6B, performing the deposition process on the planar substrate 100 produces a planar nanostructure layer 12-1 having a substantially uniform thickness (see, FIG. 6A), and performing the same process on the uneven substrate 100-1 produces a conformal nanostructure layer 12-2 that conforms to the shape of the uneven substrate and has a uniform thickness throughout the layer (see, FIG. 6B).

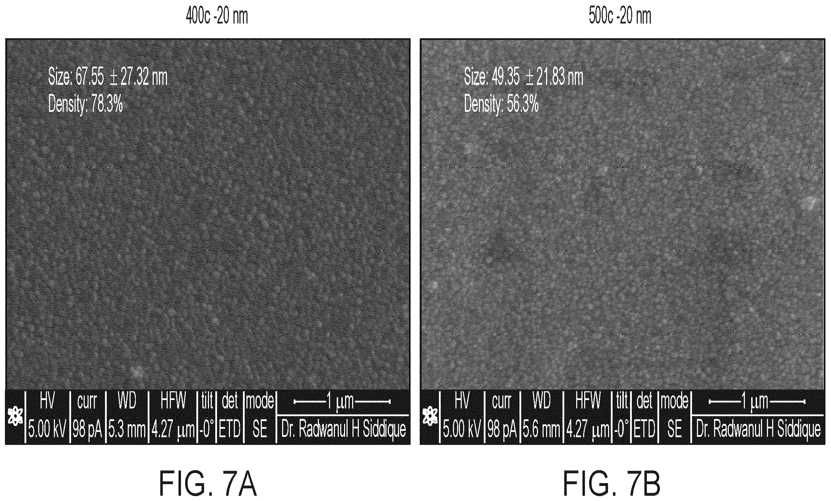

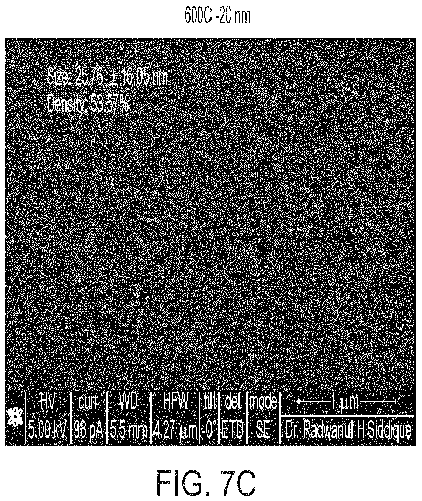

FIGS. 7A-7C illustrate the effect of the annealing temperature on size and density of the nanofeatures 13, according to some embodiments of the present invention.

As shown in FIGS. 7A-7C, for a given nanostructure layer thickness (e.g., about 20 nm), by increasing the annealing temperature (e.g., from about 400 °C to about 600 °C) the size and density of the nanofeatures 13 decrease (e.g., from a size of about 76 nm and density of about 78% down to a size of about 26 nm and density of about 54%).

Light absorption is a function of the size distribution of the nanofeatures 13 (e.g., aluminum particles), the surrounding refractive index, the gap among the nanofeatures 13 (i.e., density). Incident light excites resonances within the structure which may be predominantly confined to the gaps between nanofeatures 13. In this case, the light absorptions at 500 °C and 600 °C are similar, but greater than that at 400 °C. However, light absorption at 500 °C was more spectrally broad than light absorption at 600 °C due to the larger size dispersity. Light absorption at 600 °C was more confined to the blue color spectrum (e.g., about 50 nm wavelength), whereas light absorption at 500 °C was broader (e.g., about 100 nm) in the blue to green color spectrum. At both temperatures, light absorption was about 80%.

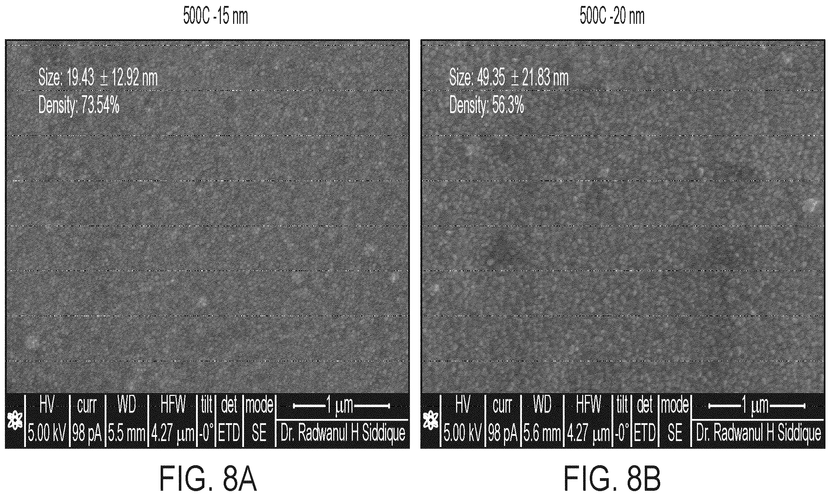

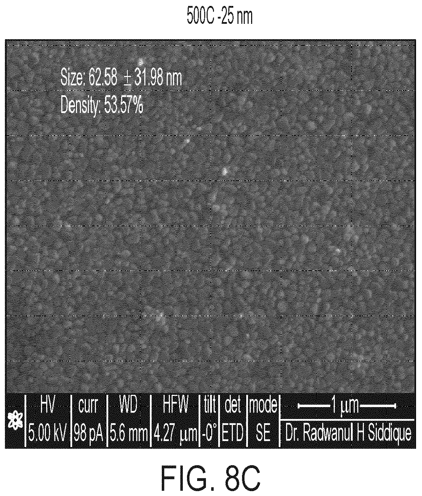

FIGS. 8A-8C illustrate the effect of the sputtering time on thickness of the nanostructure layer 12 and the size of the nanofeatures 13, according to some embodiments of the present invention.

As shown in FIGS. 8A-8C, for a given annealing temperature (e.g., of about 500 °C), by increasing the sputtering time the thickness of the nanostructure layer 12 increases (e.g., from about 15 nm to about 25 nm), the size of the nanofeatures 13 increase (e.g., from about 19 nm to about 63 nm), and the density of nanofeatures 13 decrease (e.g., from about 78% down to about 54%). Here, the dependence of optical properties on sputtering time may not be linear. For example, in the example of FIGS. 8A-8C, high light absorption may be observed in the conditions of FIG. 8B with 20 nm. That is, light absorption at 20 nm is greater than that at 15 nm, which are both greater than that at 25 nm. This may be due to more light coupling in the gaps. For example, in the case of 20 nm, there are more gaps among the nanofeatures 13 that absorbs more light. By increasing the sputtering time, the thickness increases that may lead to bridging among nanofeatures 13 and reduce gaps. Thermal conductivity may change (e.g., decrease) with the gap increase among nanofeatures 13 if the nanofeatures 13 are deposited on an insulator. When the substrate is conductive, then thermal conductivity may not change as a result of increasing sputtering time.

Thus, by tuning the sputtering time and the annealing temperature, the thickness of the nanostructure layer 12 and the size and density of the nanofeatures 13 may be adjusted to obtain a desired optical property (e.g., reflectivity/absorption for a given wavelength range). The light absorption bandwidth of the nanostructure layer 12 may increase with increasing randomness (i.e., reduced uniformity) in the size and shape of the nanofeatures 13.

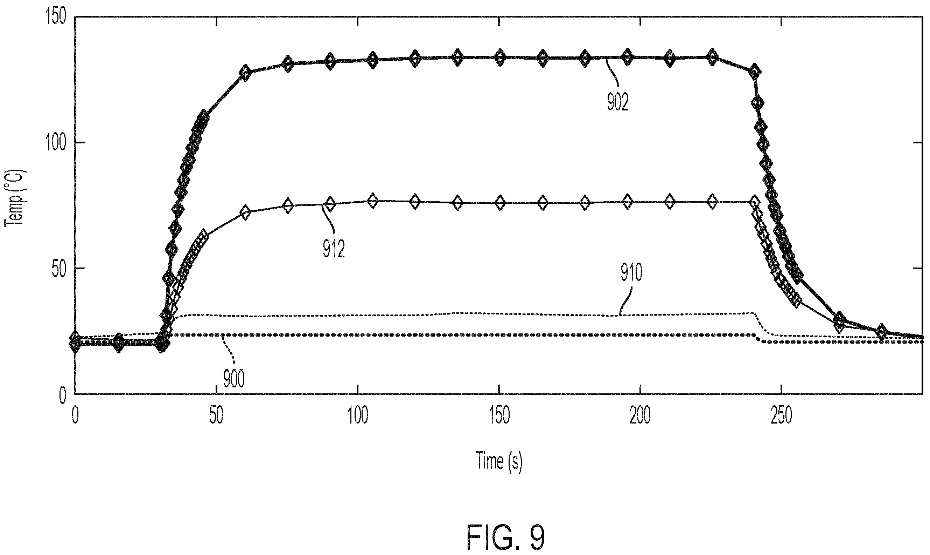

FIG. 9 is a graph illustrating the effect that the nanostructure layer 12 has on improving the maximum temperature and the heat ramp of the assay repository device 10, according to some embodiments of the present invention.

In the example of FIG. 9, when performing photothermal heating of a glass substrate (as may be the case in a PCR reaction chamber, for example) using light of 450 nm, one thermal cycle may follow the curve 900, which rises slowly to a maximum temperature of about 24 °C. The rate of temperature increase as well as the maximum temperature attained may be restrained due to glass' inability to absorb much of the incident light and also due to the rapid dissipation of heat by glass resulting from its high thermal conductivity.

When emitting the same light onto a glass substrate coated with a 20 nm thick aluminum nanostructure layer 12, the rate of temperature rise as well as the maximum temperature attained significantly increases, as shown by curve 902. For example, the maximum temperature of the glass substrate may reach about 134 °C at a temperature gradient (over the first 10 seconds) that is about 24 times greater than that of a plain glass substrate (curve 900). This is due to the ability of the nanostructure layer 12 to absorb nearly all (e.g., about 90% of) the incident light and to convert the absorbed energy to thermal energy, which is then transferred to the assay solution contained in the assay repository device 10.

Further, when performing photothermal heating of a silicon substrate (as may be the case in a microfluidic circuit, for example) using light of 450 nm, one thermal cycle may follow the curve 910, which rises slowly to a maximum temperature of about 32 °C (for a silicon substrate). However, when emitting the same light onto a silicon substrate coated with a 20 nm thick aluminum nanostructure layer 12, the rate of temperature rise as well as the maximum temperature attained significantly increases, as shown by curve 912. For example, the maximum temperature of the silicon substrate may reach about 77 °C at a temperature gradient (over the first 10 seconds) that is 1.74 times greater than that of a plain silicon substrate (curve 910). This is due to the ability of the nanostructure layer 12 to absorb nearly all (e.g., about 91% of) the incident light and to convert the absorbed energy to thermal energy, which is then transferred to the assay solution contained in the assay repository device 10.

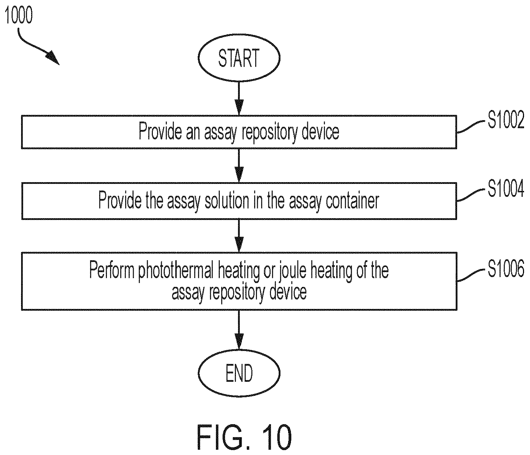

FIG. 10 illustrates a process 1000 of heating of an assay solution, according to some embodiments of the present invention.

In some embodiments, the process includes providing an assay repository (S1002) device, which includes an assay container (e.g., 14/16/19) and a nanostructure layer 12. The assay container has an interior surface and is configured to house the assay solution. The nanostructure layer 12 is conformally integrated onto the assay container and directly contacts the interior surface. The nanostructure layer 12 is also configured to directly contact any assay solution contained within the assay container. The nanostructure layer 12 is plasmonic and thermally conductive and includes a plurality of nanofeatures 13 having non-uniform sizes and/or non-uniform shapes.

In some embodiments, the process 1000 further includes providing the assay solution in the assay container (S1004) and performing photothermal heating or joule heating of the assay repository device 10 (S1006). In some examples, performing the photothermal heating includes emitting, by a light emitting diode (LED) or a laser 22-2, light of a wavelength range (e.g., near infrared to ultraviolet light) toward an interior of the assay container for absorption by the nanostructure layer 12. In other examples, joule heating of the assay repository device 10 includes bringing a joule heater 22-1 in contact with the assay repository device 10 and generating heat by the joule heater 22-1 for transfer to the assay repository device 10.

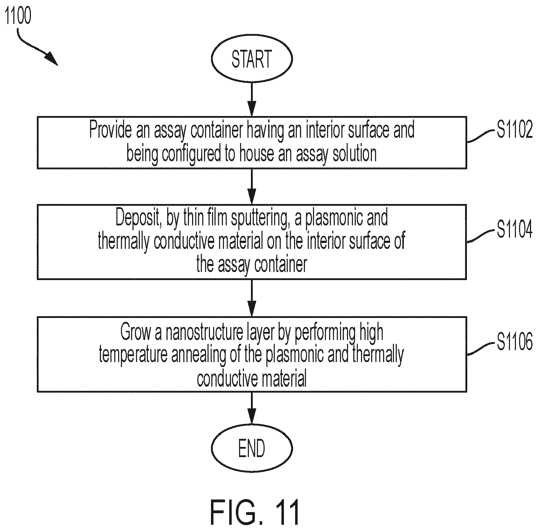

FIG. 11 illustrates a process 1100 of manufacturing an assay repository device, according to some embodiments of the present invention.

In some embodiments, the process 1100 includes providing an assay container (e.g., 14/16/19) that has an interior surface and is configured to house an assay solution (S1102). The process 1100 further includes depositing, by thin film sputtering, a plasmonic and thermally conductive material on the interior surface of the assay container (S1104) and growing a nanostructure layer 12 within the assay container by performing high temperature annealing of the plasmonic and thermally conductive material (S1106). The sputtered material may be about 4 nm to about 25 nm thick, and the annealing process may include raising the temperature of the assay container to about 400 °C to about 800 °C and then cooling it down to room temperature.

Accordingly, as described above, embodiments of the present invention provide an assay repository device that is integrated with a conformal multifunctional nanostructure layer, which enables rapid and efficient heat transfer to an assay sample from a light source or a joule heater. The integrated nanostructure layer has tunable plasmonic properties and may be able to absorb most or nearly all of light in the ultraviolet-visible-near infrared wavelength ranges. The nanostructure layer may be conformally integrated onto all forms of PCR reaction chambers and enables high heat ramps and cool down rates through photothermal or joule heating. Accordingly, the nanostructure later enables rapid lysis and thermocycling, which yields shorter testing time.

While this invention has been described in detail with particular references to illustrative embodiments thereof, the embodiments described herein are not intended to be exhaustive or to limit the scope of the invention to the exact forms disclosed. Persons skilled in the art and technology to which this invention pertains will appreciate that alterations and changes in the described structures and methods of assembly and operation can be practiced without meaningfully departing from the principles, spirit, and scope of this invention, as set forth in the following claims and equivalents thereof.

It will be understood that, although the terms "first," "second," "third," etc., may be used herein to describe various elements, components, and/or sections, these elements, components, and/or sections should not be limited by these terms. These terms are used to distinguish one element, component, or section from another element, component, or section. Thus, a first element, component, or section discussed above could be termed a second element, component, or section, without departing from the spirit and scope of the invention.

It will be understood that the spatially relative terms used herein are intended to encompass different orientations of the device in use or in operation, in addition to the orientation depicted in the figures. The device may be otherwise oriented (e.g., rotated 90 degrees or at other orientations) and the spatially relative descriptors used herein should be interpreted accordingly. In addition, it will also be understood that when a layer is referred to as being "between" two layers, it can be the only layer between the two layers, or one or more intervening layers may also be present.

The terminology used herein is for the purpose of describing particular embodiments and is not intended to be limiting of the invention. As used herein, the singular forms "a" and "an" are intended to include the plural forms as well, unless the context clearly indicates otherwise. It will be further understood that the terms "include," "including," "comprises," and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Further, the use of "may" when describing embodiments of the invention refers to "one or more embodiments of the invention." Also, the term "exemplary" is intended to refer to an example or illustration.

It will be understood that when an element or component is referred to as being "connected to" or "coupled to" another element or component, it can be directly connected to or coupled to the other element or component, or one or more intervening elements or components may be present. When an element or layer is referred to as being "directly connected to" or "directly coupled to" another element or component, there are no intervening elements or components present.

As used herein, the terms "substantially," "about," and similar terms are used as terms of approximation and not as terms of degree, and are intended to account for the inherent variations in measured or calculated values that would be recognized by those of ordinary skill in the art.

For the purposes of this disclosure, "one or more of X, Y, and Z", "at least one of X, Y, or Z" and "at least one selected from the group consisting of X, Y, and Z" may be construed as X only, Y only, Z only, or any combination of two or more of X, Y, and Z, such as, for instance, XYZ, XYY, YZ, and ZZ.

As used herein, the terms "use," "using," and "used" may be considered synonymous with the terms "utilize," "utilizing," and "utilized," respectively.

Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112, first paragraph, and 35 U.S.C. § 132(a).

The controller and/or any other relevant devices or components according to embodiments of the present invention described herein may be implemented by utilizing any suitable hardware, firmware (e.g., an application-specific integrated circuit), software, or a suitable combination of software, firmware, and hardware. For example, the various components of the controller may be formed on one integrated circuit (IC) chip or on separate IC chips. Further, the various components of the controller may be implemented on a flexible printed circuit film, a tape carrier package (TCP), a printed circuit board (PCB), or formed on the same substrate. Further, the various components of the controller may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random-access memory (RAM). The computer program instructions may also be stored in other non-transitory computer-readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

While this invention has been described in detail with particular references to illustrative embodiments thereof, the embodiments described herein are not intended to be exhaustive or to limit the scope of the invention to the exact forms disclosed. Persons skilled in the art and technology to which this invention pertains will appreciate that suitable alterations and changes in the described structures and methods can be practiced without meaningfully departing from the principles, spirit, and scope of this invention, as set forth in the following claims and equivalents thereof.

## Claims

1. An assay repository device for photothermal or joule heating, the assay repository device comprising:
an assay container having an interior surface and being configured to house an assay solution; and
a nanostructure layer conformally integrated onto the assay container and directly contacting the interior surface, the nanostructure layer being plasmonic and thermally conductive, and comprising a plurality of nanofeatures having non-uniform sizes and/or non-uniform shapes.

2. The assay repository device of claim 1, wherein the assay container comprises a reaction tube, a well plate, a lab-on-chip, or a microarray.

3. The assay repository device of claim 1 or 2, wherein the nanostructure layer has a uniform thickness along the interior surface of the assay container, and
wherein the interior surface comprises a non-flat surface portion.

4. The assay repository device of any one of claims 1 to 3, wherein the nanostructure layer is configured to be directly contacting the assay solution in the assay container.

5. The assay repository device of any one of claims 1 to 4, wherein the nanostructure layer is configured to increase heat ramp and cooldown rates of the assay repository device to enable rapid lysis or thermocycling.

6. The assay repository device of any one of claims 1 to 5, wherein the nanostructure layer is configured to absorb more than 90% of incoming light in an ultraviolet to near infrared wavelength range, and
wherein the nanostructure layer has a thermal conductivity greater than 100 W/mK.

7. The assay repository device of any one of claims 1 to 6, wherein each one of the plurality of nanofeatures has a circular shape, a spherical shape, an ellipsoidal shape, a prismatic shape, or a tapered shape.

8. The assay repository device of any one of claims 1 to 7, wherein the nanostructure layer comprises at least one of a metal, a doped semiconductor, or an undoped semiconductor.

9. The assay repository device of claim 8, wherein the nanostructure layer comprises at least one of aluminum, Al, gold, Au, silver, Ag, titanium, Ti, tungsten, W, copper, Cu, palladium, Pd, tantalum, Ta, tantalum nitride, TaN, titanium nitride, TiN, Niobium, Nb, or p-doped silicon, p Si.

10. A method of heating of an assay solution, the method comprising:
providing the assay repository device according to any one of claims 1 to 9; and
performing photothermal heating or joule heating of the assay repository device.

11. The method of claim 10, further comprising:
providing the assay solution in the assay container.

12. The method of claim 10 or 11, wherein the performing the photothermal heating or the joule heating of the assay repository device comprises:
emitting, by a light emitting diode, LED, or a laser, light of a wavelength range toward an interior of the assay container for absorption by the nanostructure layer.

13. The method of claim 12, wherein the wavelength range comprises an ultraviolet to near infrared wavelength range.

14. The method of claim 10 or 11, wherein the performing the photothermal heating or the joule heating of the assay repository device comprises:
providing a joule heater in contact with the assay repository device; and
generating heat by the joule heater.
